Europäisches Patentamt

(19) European Patent Office

Office européen des brevets

(11) Publication number : **0 330 001 B1**

(12) **EUROPEAN PATENT SPECIFICATION**

(45) Date of publication of patent specification :
19.07.95 Bulletin 95/29

(51) Int. Cl.⁶ : **H03M 13/00**

(21) Application number : **89101950.7**

(22) Date of filing : **03.02.89**

(54) **System devices and algorithm for the error correction in digital transmissions with "BCH" coding/decoding.**

(30) Priority : **23.02.88 IT 1948788**

(43) Date of publication of application :
**30.08.89 Bulletin 89/35**

(45) Publication of the grant of the patent :
**19.07.95 Bulletin 95/29**

(84) Designated Contracting States :
**BE CH DE ES FR GB GR LI NL SE**

(56) References cited :
**EP-A- 0 204 576**
**US-A- 4 649 541**
**Proceedings of the symposium on computer processing in communications; 8-10 April 1969; NEW YORK pages 401 - 413; A. M. MICHELSON: "Computer implementation of decoders for several BCH codes"**
**NTIS TECH NOTES. no. 4, April 1986, SPRINGFIELD, VA US page 405 K.Y. LIU:"Modular-VLSI Reed-Solomon decoder"**

(73) Proprietor : **ALCATEL ITALIA Società per Azioni**
**Via Monte Rosa, 15**
**I-20149 Milano (IT)**

(72) Inventor : **Cucchi, Silvio**
**Via S. Inventio 9**
**I-20080 Gaggiano (MI) (IT)**
Inventor : **Pogliani, Luciano**
**Viale Monza 177**
**I-20126 Milano (IT)**
Inventor : **Parladori, Giorgio**
**Via S. Ne Porta Palio 36**
**I-37022 Verona (IT)**

(74) Representative : **Strehl Schübel-Hopf Groening & Partner**
**Maximilianstrasse 54**
**D-80538 München (DE)**

## Description

The present invention refers to a system for the error correction in digital transmission using the so called "BCH" coding/decoding technics.

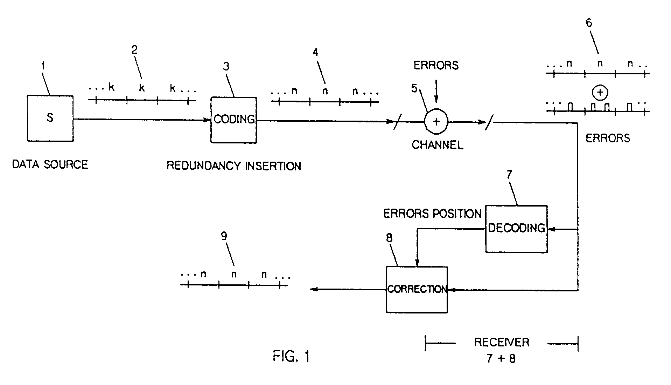

It is well-known to apply the so called "BCH" (Bose-Chaudhuri-Hocquenghem Codes) coding technique in the field of the digital data transmission: (see e.g. the book "Error Correction Codes" by W.W. Peterson and E.J. Weldon Jr., IInd edition, The MIT Press) for the protection of transmitted symbol stream from the errors introduced into the transmission channel. This technique provides the association of each block of k information symbols generated by the data source with a package of n-k redundancy symbols selected according to a relationship that shall be described in the following, the transmission of the whole block including n symbols by means of the transmission channel, at the output of which the receiver shall be able, using the analysis of the relationships established among the received symbols and the reduncancy package contained in these symbols, to establish the presence of any errors introduced by the channel and the positions in which they were introduced, allowing in this manner the right correction and reconstruction of the original block, as it was generated by the data source. Fig. 1 schematizes a conventional system, in which the symbols represent respectively:

1        : Data source under the form of symbols in time serial succession.
2        : Subdivision of the serial sequence of symbols emitted by S in blocks, each of these blocks including k successive symbols.
3        : Encoder for the calculation of n-k redundancy symbols related to each block of k data symbols.
4        : Whole sequence of symbols to be transmitted, in which different blocks of n successive symbols are distinguished, each of these blocks including k data symbols and n-k redundancy symbols.
5        : Channel in which the symbol blocks are transmitted, made-up of the transmission means; owing to noise present in the channel 5, a certain number of symbols transmitted are distorted, so that they become wrong.
6        : Sequence of symbols received by the receiver 7+8, which can be represented by the overlapping of the transmitted original sequence with the error sequence introduced by the channel.
7        : Decoder that carries out the calculation of locations of any errors introduced by the channel in each block of n symbols.
8        : Correction of symbols received in the positions detected by the decoder.
9        : Sequence of symbols in which the errors are corrected, and which is coincident with the original transmitted sequence. The performances of this technique, intended as the number C of errors that can be decoded within the single block of n symbols, depend on the number (n-k) of redundancy symbols included in each block; in detail, if $2^{N-1} \leq n \leq 2^N-1$, it must be: $n-k = C \cdot N$
         (definition A).

The algorithms used for associating the redundancy symbols to the information symbols in the transmitted data stream and for decoding any error positions in the received data stream are well-known and described in a general mathematic form in the technical literature. As regards the transmission section, the algorithms are related to a relatively simple circuit implementation; as regards the reception section they are more complex and their immediate transformation in circuit form could cause constructions unsatisfactory under the point of view of costs, overall dimensions and consumptions. For getting a sufficient implementation, it is necessary to make a rewriting of the decoding algorithm using equations that allow the exact calculation of the considered magnitudes and can be carried out by means of more simple circuits and a reduced number of components. In detail the described system is generated by a rewriting of the decoding algorithm, so that the related execution circuit shows a reduced complexity, suitable for allowing the integration of many systems operating in the same time in a sole device with consequent advantages of costs, overall dimensions and consumptions.

Here the theoretical fundaments of the "BHC" correction technics, applied to the case of binary symbols are shortly illustrated.

Generally speaking, when there is a generical sequence of L binary symbols (bit)
$b_0, b_1, b_2, .... b_{L-1}$,        $b_j = 0$ or $1$,
it can be thought to be associated univocally to the polynomial having a L-1 degree

$$b_0 + b_1 X + b_2 X^2 + .... + b_{L-1} X^{L-1} = \sum_{0j}^{L-1} b_j X^j = P(x)$$

During the coding phase, the BHC technique provides the calculation, starting from the polynomial I(x) associated to the generic sequence of k bits emitted by the source S:

$b_0, b_1, b_2, .... b_{k-1}, b_{k-1}$ emitted as first symbol, $b_0$ emitted as last symbol, the polynomial of n-1 degree

$$T(x) = I(x) \cdot X^{n-k} + H(x)$$

with the polynomial H(x) having n-k-1 degree obtained as the remainder of the division $I(x) \, x^{n-k}/g(x)$; being g(x) a polynomial of degree C.N, with C being as defined formerly, to be selected suitably for guaranteeing the performance of the method as regards the protection from errors. The literature indicates the criteria for selecting g(x) in function of N: after having defined a Galois's extended field with distinct elements $(1, a, a^2, a^3, .... a^{n-1})$, g(x) must become zero substituting the 2C+1 successive roots: $a, a^2,..., a^{2C+1}$.

Considering the binary case, the addition operation in the Galois's extended field is defined as modulo 2, that is for any element Z, it is: $Z+Z = Z-Z = 0$, and for any P(x), it is: $P(x^2) = P^2(x)$. As its is surely: $I(x) \cdot x^{n-k} = Q(x) \cdot g(x) + H(x)$, it is: $T(x) = Q(x) \cdot g(x)$, and therefore also the polynomial T(x) is zeroed substituting in it the same roots $a, a^2,..., a^{2C+1}$.

Using the encoder it is possible to obtain in a relatively simple manner the bit sequence representing the remainder H(x), with the data sequence transmitted from the source and the equation of g(x) being assigned; finally transmitted is the sequence of n bit representing the whole polynomial T(x), the so called "code word", formed by the k bits transmitted by S, followed by the (n-k) bit of the remainder

$$t_0, t_1, t_2 ..., t_{n-k-1}, t_{n-k}, t_{n-k+1}, ... t_{n-1};$$

where:

$t_0$: last transmitted bit, $t_{n-1}$: first transmitted bit. With the aim of illustrating more clearly the operations required by the decoder, we refer to the case of the code for the protection of 2 block errors, C=2, as it happens in actual devices; therefore the successive roots of g(x) are: $a, a^2, a^3, a^4, a^5$.

The output sequence of the transmission channel, in conjuction with the generic block, $r_0, r_1, r_2, ...., r_{n-1}$ is represented by a polynomial

$$V(x) = T(x) + E(x),$$

in which the sequence really transmitted is overlapped with a sequence formed by 2 possible errors in generic positions corresponding to $t_i$ and $t_j$, being i and j the unknown values to be established:

$$E(x) = x^i + x^j$$

Therefore in general the polynomial V(x) is no more zeroed for x=a, $x=a^3$, as it happened in T(x), but it is equal to:

$$V(a) = a^i + a^j$$
$$V(a^3) = a^{3i} + a^{3j}$$

Therefore we have:

$$V^3(a) = a^{3i} + a^{3j} + 3a^i \, a^{2j} + 3a^{2i} \, a^j$$

that, in module 2, brings to:

$$V^3(a) = V(a^3) + a^i \, a^j \cdot V(a),$$

from which, replacing $a^j = V(a) + a^i$, it is obtained that the unknown values i and j are the values that satisfy the equation in p

$$V(a) \, a^{2p} + V(a^2) \, a^p + [V^3(a) + V(a^3)] = 0$$

The solutions of this equation must be searched making all possible n checks, starting from the attempt of order p = n + 1 until the attempt of order p = 0. It must be observed that the lack of errors is decoded immediately owing to the fact that $V(a) = V(a^3) = 0$ and therefore the necessity of any check is excluded.

If 1 or 2 errors are present, only 1 or 2 values of p shall lead, making the attempt sequence, to an exact check, indicating immediately the positions i and j of the received bits to be corrected within the received sequence.

The attempt with p = n-1 leads to the check whether

$$V(a) + a \, V(a^2) + a^2 \, [V^3(a) + V(a^3)] = 0$$

(remembering that in Galois's extended field $a^n = a^0 = 1$).

The following generic attempt of k-order, for p = n-k, leads to the check whether

$$V(a) + a^k \, V(a^2) + a^{2k} \, [V^3(a) + V(a^3)] = V(a) + S_{1,k} + S_{2,k} = 0$$

from which it is evident that the considered addends of the generic k-oder check (k= 1....n) can be obtained by iterative calculation as

$$S_{1,k} = a \cdot S_{1,k-1}$$
$$S_{2,k} = a^2 \cdot S_{2,k-1}$$

The exactness of the k-order check establishes the correction of the received k-order bit.

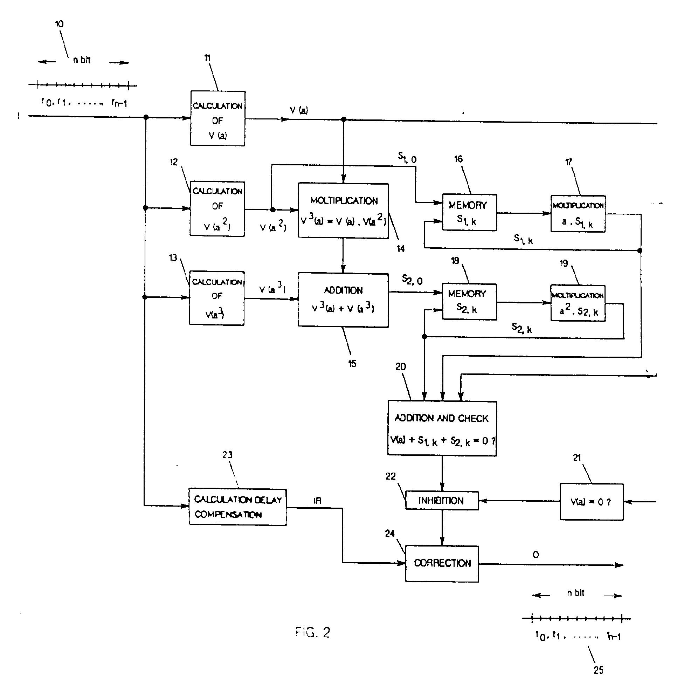

The indicated correction technique is well-known in literature as "Chien's search method". If it is used as described, it allows the use of a classic receiver structure as the one described in Fig. 2, in which the referred blocks represent respectively:

10     : Single block I of n successive bits received by the receiver, with values $r_0, r_1, r_2, .... , r_{n-1}$.

11  : Calculation of the quantity $V(a)$ considering the block of n bits received.

12  : Calculation of the quantity $V(a^2)$ considering the block of n bits received.

13  : Calculation of the quantity $V(a3)$ considering the block of n bits received.

14  : Calculation of the quantity $V^3(a)$ by the multiplication: $V(a) . V(a^2)$.

15  : Calculation of the addition: $V^3(a) + V(a^3)$.

16  : Storage of the addend $S_{1,k}$ used for checking the accuracy of bit received having the value $r_{n-k}$.

17  : Calculation of the addend $S_{1,k+1}$ by the multiplication: $a . S_{1,k}$, necessary for checking the accuracy in the successive bit.

18  : Storage of the addend $S_{2,k}$ used for checking the accuracy of bit received having the value $r_{n-k}$.

19  : Calculation of the addend $S_{2,k+1}$ by the multiplication: $a . S_{2,k}$, necessary for checking the accuracy in the successive bit.

20  : Calculation of the whole addition: $V(a) + S_{1,k} + S_{2,k}$ and check of its zeroing, indicating the presence of an error in the bit received having the value $r_{n-k}$.

21  : Check of a possible zeroing of the single quantity $V(a)$, indicating the absence of errors in the whole block of n received bits, independently from the result of calculation no. 20.

22  : Inhibition of the indication for correction as a result of the calculation no. 20 as a function of the check made in step 21.

23  : Delay line by means of which each bit received with I is stored for the time necessary so that the decoder is ready for the accuracy check. Then the block IR coincides with I, with an approximation due to a prefixed time shift.

24  : Execution or non-execution of the correction as a function of the results of steps 20 and 21.

25  : Single block 0 of n successive bits at the output from the decoder, with values $t_0, t_1, ......, t_{n-1}$ coinciding with the values really transmitted by the encoder located upstream of the transmission channel.

A drawback of the conventional systems, in particular of the system indicated in Fig. 2, is that the direct implementation of the functions foreseen in the said Fig. 2, requires an extremely complex hardware as regards the overall dimensions, costs, consumptions, development, etc..

An apparatus which operates similar to that described above and which includes the features set forth in the first part of claim 1 is known from EP-A-0 204 576.

## SUMMARY OF THE INVENTION

It is an object of the present invention to provide a modified version of the "BCH" algorithm that allows to avoid the above mentioned drawbacks. Another object is to provide implementation devices for this algorithm that are extremely simple, cheap, and show a low consumption and an easy integration in the system.

The main characteristics of the invention are specified in the appended claim 1.

Reducing the circuit complexity is achieved by the selection of procedures suitable for the calculation of the magnitudes $V(a)$, $V(a^2)$, as alternatives to what is implied by the immediate equations:

$$V(a) = \sum_{j=0}^{n-1} r_j \cdot a^j \quad ; \quad V(a^2) = \sum_{j=0}^{n-1} r_j a^{2j}$$

In addition to this fact, a decisive contribution for a remarkable implementation is obtained by the selection of an alternative procedure for the calculation of the magnitude $V^3(a) + V(a^3)$, that allows to exclude completely the necessity of the multiplication block $V^3(a) = V(a) . V(a^2)$, that surely should be the more expensive block among the blocks included in the indicated scheme, as it is a multiplication between factors completely variable when the input sequence $V(x)$ changes, (differing from the multiplication blocks $a . S_{1,k}$ and $a^2 . S_{1,k}$, in which one factor of the two factors has a constant value and therefore requires a relatively simple circuit).

All these possibilities have now been used in the embodiment of the system and device according to the invention.

Now we shall illustrate the mathematic units of these alternative procedures.

Assuming the bit sequence received by the receiver is

$$r_0 \quad r_1 \quad r_2 \quad \cdots\cdots\cdots \quad r_{n-1}$$

—|—|—|—|——|—|————→

being $r_{n-1}$ received as first bit, $r_0$ as last bit, the associated polynomial

$$V(x) = r_0 + r_1 x + r_2 x^2 + \ldots + r_{n-1} x^{n-1}$$

can be written

$$V(x) = ((..((r_{n-1} \cdot x + r_{n-2}) \cdot x + r_{n-3}) \cdot x + .. + r_2) \cdot x + r_1) \cdot x + r_0$$

in which further

$$V(a) = ((..((r_{n-1} \cdot a + r_{n-2}) \cdot a + r_{n-3}) \cdot a + .. + r_2) \cdot a + r_1) \cdot a + r_0$$
$$V(a^2) = ((..((r_{n-1} \cdot a^2 + r_{n-2}) \cdot a^2 + r_{n-3}) \cdot a^2 + .. + r_2) \cdot a^2 + r_1 = \cdot a^2 + r_0$$
$$V(a^3) = ((..((r_{n-1} \cdot a^3 + r_{n-2}) \cdot a^3 + r_{n-3}) \cdot a^3 + .. + r_2) \cdot a^3 + r_1) \cdot a^3 + r_0$$

Therefore these iterative equations can be obtained:

$$V_{i+1}(a) = V_i(a) \cdot a + r_{n-1-i}, V_0(a) = 0 \quad (1)$$
$$V_{i+1}(a^2) = V_i(a^2) \cdot a^2 + r_{n-1-i}, V_0(a^2) = 0 \quad (2)$$
$$V_{i+1}(a^3) = V_i(a^3) \cdot a^3 + r_{n-1-i}, V_0(a^3) = 0 \quad (3)$$

Therefore the calculation of $V(a)$ and $V(a^2)$ can be carried out using the updatings (1) and (2) respectively, carried out at each successive bit $r_{n-1-i}$ received from the receiver, with $i = 0, \ldots n-1$, and the investigated magnitudes are obtained at the end of the sequence, e.g.

$$V(a) = V_{i+1}(a), i = n-1,$$
$$V(a^2) = V_{i+1}(a^2), i = n-1.$$

The operations required by (1) and (2) are particularly simple in this case, as they involve the sole multiplication by a constant factor and the addition with one bit. In a similar way, using the equation (3), $V(a^3)$ could be calculated.

But it is more profitable to establish an iterative calculation for the whole magnitude $V(a^3) + V^3(a)$, defining an iterative variable magnitude $G_i(a) = V_i(a^3) + V_i^3(a)$. In fact it happens, considering that the operations are made in module 2,

$$G_{i+1}(a) = V_{i+1}(a^3) + V_{i+1}^3(a) =$$
$$= V_i(a^3) \cdot a^3 + r_{n-1-i} + [V_i(a) \cdot a + r_{n-1-i}]^3 =$$
$$= V_i(a^3) \cdot a^3 + r_{n-1-i} + V_i^3(a) \cdot a^3 + V_i^2(a) \cdot a^2 \cdot r_{n-1-i} + V_i(a) \cdot a \cdot$$
$$\cdot r_{n-1-i} + r_{n-1-i} =$$
$$= [V_i(a^3) + V_i^3(a)] \cdot a^3 + [V_i(a) \cdot a + V_i(a^2) a^2] \cdot r_{n-1-i} =$$
$$= G_i(a) \cdot a^3 + [V_{i+1}(a) + V_{i+1}(a^2)] \cdot r_{n-1-i}$$

this equation using the already calculated terms $v_{i+1}(a)$ and $V_{i+1}(a^2)$, and requiring advantageously simple operations, such as multiplications by a constant factor or by a bit (either 0 or 1) and an addition. Also in this case the desired magnitude is obtained at the end of the received sequence:

$$V(a^3) + V^3(a) = G_{i+1}(a), i = n-1.$$

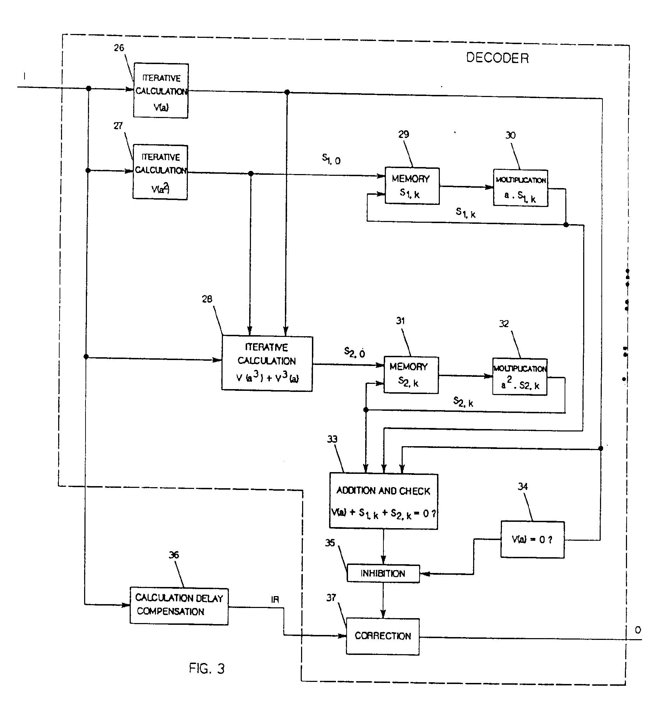

According to the invention, the rewriting of the decoding algorithm causes the formation of the receiver structure described in Fig. 3; all operations involved are now additions or multiplications by constant factors, that can be obtained with a relatively reduced circuit complexity. This in turn offers the possibility of integrating more systems of this type (except the balancing block for the calculation delay) using a sole semi-custom device, suitable for simultaneously processing many independent data sequences. Fig. 3 shows blocks that represent respectively:

26 : Iterative calculation of the magnitude $V(a)$ carried out according to the equation (1).

27 : Iterative calculation of the magnitude $V(a^2)$ carried out according to the equation (2).

28 : Iterative calculation of the magnitude $V(a^3) + V^3(a)$ carried out according to the equation (3').

The functions applied by the 29th, 30th blocks, etc. to the 37th block remain identical to the functions of the 16th to 24th blocks respectively, as described with reference to Fig. 2.

According to a preferred and advantageous embodiment of the invention, 8 "BCH" coding/decoding systems operating on 8 independent sequences of binary data are integrated in just one device and controlled by a sole central clock unit, owing to the fact that control commands can be used in common among the various systems.

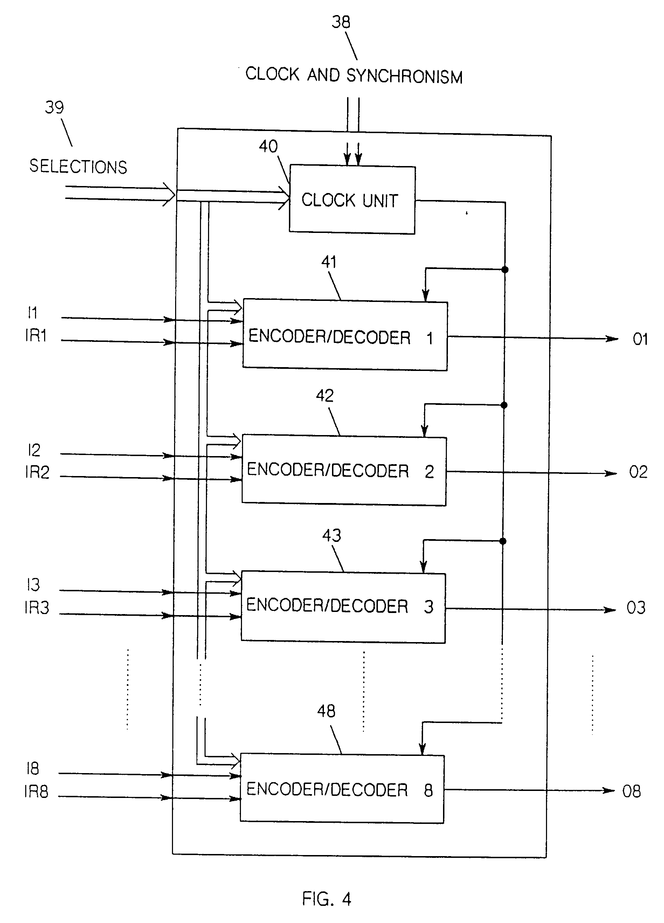

Fig. 4 represents the said preferred embodiment, in which the referred blocks indicate respectively:

38 : The external SYNCHRONISM signal indicates to the device the start time of each block of n bit to be generated or to be received, supposing the device is set for carrying out the functions of an encoder or a decoder, respectively. The external CLOCK signal indicates to the

5

device the start time of each single bit.

39 : The SELECTIONS are a set of external signals by which the device is set for:
. carrying out the encoder or decoder functions;
. processing blocks of arbitrary n length;
. processing a redundancy n-k length equal to 16 or 18 bits within each block of n bits;
. processing successive blocks of n bits or successive pairs of blocks of n bits alternated internally with one another;

40 : This clock unit generates the control signals by which each coding/decoding unit can locate and process the different blocks of n bits within the continuous sequence of bits presented to its input.

41, 42,...48 : eight systems connected in parallel for the coding/decoding use, each system being realised according to the criteria illustrated with reference to Fig. 3, and each system operating with its own different continuous input sequence.

The systems carry out the coding functions in transmission data stream, or decoding in reception data stream under the control of an external selection (the coding function is carried out by a limited part of the decoding circuit by means of a simple internal reconfiguration).

Further saving in circuitry achieved by the selected system architecture has allowed the integration, within the fulfilled device, of other internal reconfiguration possibilities. that can be controlled by external adjustable selections. These selections are the following ones:
. possibility of processing in a redundancy length equal to 16 or 18 bit for each input data block (or. keeping constant the performance C=2, possibility of applying the functions related to a value N=8 or N=9, according to the definition A);
. possibility of changing the whole n length of blocks processed within the field $CN \leqq n \leqq 2^N-1$;
. possibility of processing a single code word for each one of n bits in input (in the receiving mode; k bit in the transmitting mode) or possibility of processing 2 code words interlocked bit by bit for each 2.n bit in input (in the receiving mode; 2.k bit in the transmitting mode).

Obviously the invention has been described for clarity's sake with reference to the drawings and examples but is not limited to these embodiments as it is susceptible of changes and modifications.

## Claims

1. An apparatus for error correction in digital transmission, using BCH coding/decoding, comprising
   means (26) for forming the expression V(a) by recursive calculation of $V_{i+1}(a) = V_i(a) \cdot a + r_{n-1-i}$; with $V_o(a) = 0$;
   means (27) for forming the expression $V(a^2)$ by recursive calculation of $V_{i+1}(a^2) = V_i(a^2) \cdot a^2 + r_{n-1-i}$; with $V_o(a^2) = 0$;
   means (28) for forming the expression $V(a^3) + V^3(a)$; and
   means (37) using these expressions for establishing the position of any errors and for correcting them;
   **characterised** in that the means (28) for forming the expression $V(a^3) + V^3(a)$ performs a recursive calculation of $V_{i+1}(a^3) + V_{i+1}^3(a) = [V_i(a^3)+V_i^3(a)] \cdot a^3 +[V_{i+1}(a)+V_{i+1}(a^2)] \cdot r_{n-1-i}$; with $V_o(a^3) = 0$; wherein
   n = number of bits received in a block,
   $r_i$ = value of the i-th bit received,
   $V(a)$, $V(a^2)$, $V(a^3)$ = quantities concerning the block of bits received,
   $V_i(a)$ = quantity concerning the i-th bit.

2. The apparatus of claim 1, comprising a central clock unit (40) for controlling said calculating means (26...28).

3. The apparatus of claim 1 or 2, comprising a plurality of BCH encoders/decoders (41...48) for processing a corresponding plurality of independent bit sequences.

## Patentansprüche

1. Vorrichtung zur Fehlerkorrektur bei der Digitalübertragung unter Verwendung von BCH-Codierung/Decodierung, umfassend

eine Einrichtung (26) zur Bildung des Ausdrucks V(a) durch rekursive Berechnung von $V_{i+1}(a) = V_i(a) \cdot a + r_{n-1-i}$; mit $V_o(a) = 0$;

eine Einrichtung (27) zur Bildung des Ausdrucks $V(a^2)$ durch rekursive Berechnung von $V_{i+1}(a^2) = V_i(a^2) \cdot a^2 + r_{n-1-i}$; mit $V_o(a^2) = 0$;

eine Einrichtung (28) zur Bildung des Ausdrucks $V(a^3) + V^3(a)$; und

eine Einrichtung (37), die anhand dieser Ausdrücke die Lage etwaiger Fehler feststellt und sie korrigiert;

dadurch **gekennzeichnet**, daß die Einrichtung (28) zur Bildung des Ausdrucks $V(a^3) + V^3(a)$ eine rekursive Berechnung von $V_{i+1}(a^3) + V_{i+1}^3(a) = [V_i(a^3) + V_i^3(a)] \cdot a^3 + [V_{i+1}(a) + V_{i+1}(a^2)] \cdot r_{n-1-i}$; mit $V_o(a^3) = 0$ durchführt, wobei

| | |
|---|---|
| n | = Anzahl der in einem Block enthaltenen Bits, |
| $r_i$ | = Wert des i-ten empfangenen Bits, |
| $V(a), V(a^2), V(a^3)$ | = den Block der empfangenen Bits betreffende Größen, |
| $v_i(a)$ | = das i-te Bit betreffende Größe. |

2. Vorrichtung nach Anspruch 1, mit einem zentralen Taktgeber (40) zur Steuerung der Recheneinrichtungen (26... 28).

3. Vorrichtung nach Anspruch 1 oder 2, mit mehreren BCH-Codierern/Decodierern (41...48) zur Bearbeitung einer entsprechenden Vielzahl unabhängiger Bitsequenzen.

## Revendications

1. Dispositif pour la correction d'erreurs dans les transmissions numériques, utilisant un codage/décodage BCH, comprenant

un moyen (26) pour former l'expression V(a) par calcul récurrent de $V_{i+1}(a) = V_i(a) \cdot a + r_{n-1-i}$; avec $V_o(a) = 0$;

un moyen (27) pour former l'expression V(a¨) par calcul récurrent de $V_{i+1}(a^\cdot) = V_i(a^\cdot) \cdot a^\cdot + r_{n-1-i}$; avec $V_o(a^\cdot) = 0$;

un moyen (28) pour former l'expression $V(a^3) + V^3(a)$; et

un moyen (37) utilisant ces expressions pour établir la position d'erreurs éventuelles et pour les corriger;

**caractérisé** en ce que le moyen (28) pour former l'expression $V(a^3) + V^3(a)$ effectue un calcul récurrent de

$$V_{i+1}(a^3) + V_{i+1}^3(a) = [V_i(a^3) + V_i^3(a)] \cdot a^3 + [V_{i+1}(a) + V_{i+1}(a^\cdot)] \cdot r_{n-1-i};$$

avec $V_o(a^3) = 0$; où

| | |
|---|---|
| n | = nombre de bits reçus dans un bloc, |
| $r_i$ | = valeur du i-ième bit reçu |
| $V(a), V(a^\cdot), V(a^3)$ | = quantités concernant le bloc de bits reçus, |
| $V_i(a)$ | = quantité concernant le i-ième bit |

2. Dispositif selon la revendication 1, comprenant une unité d'horloge centrale (40) pour commander lesdits moyens de calcul (26...28).

3. Dispositif selon la revendication 1 ou 2, comprenant une pluralité de codeurs/décodeurs BCH (41...48) pour traiter une pluralité correspondante de séquences binaires indépendantes.

FIG. 1

FIG. 2

FIG. 3

FIG. 4